Europäisches Patentamt

European Patent Office

Office européen des brevets

(19)

(11) Publication number: **0 029 693**
**B1**

# EUROPEAN PATENT SPECIFICATION

(12)

(45) Date of publication of patent specification: **07.09.83**

(21) Application number: **80304122.7**

(22) Date of filing: **18.11.80**

(51) Int. Cl.³: **B 23 K 15/00,**
**H 01 J 37/315,**
**H 01 J 37/15**

(54) Electron beam welding machine.

(30) Priority: **19.11.79 JP 148914/79**

(43) Date of publication of application:
**03.06.81 Bulletin 81/22**

(45) Publication of the grant of the patent:
**07.09.83 Bulletin 83/36**

(84) Designated Contracting States:
**DE FR GB**

(56) References cited:
**EP - A - 0 017 405**
**US - A - 3 049 608**
**US - A - 3 082 316**
**US - A - 3 483 350**
**US - A - 3 617 686**

**IBM TECHNICAL DISCLOSURE BULLETIN, vol.
19, no. 9, February 1977, page 3296 New York,
U.S.A. D. E. GRANT et al.: "Light source
alignment"**

(73) Proprietor: **Hitachi, Ltd.**
**5-1, Marunouchi 1-chome**
**Chiyoda-ku Tokyo 100 (JP)**

(72) Inventor: **Kita, Hisanao**
**4-17-22 Suwa**
**Hitachi Ibaraki (JP)**
Inventor: **Karatsu, Yoshimori**
**203-6 Takahagi**
**Takahagi-shi Ibaraki (JP)**
Inventor: **Nakazaki, Takamitsu**
**2590-22 Oaza-Ishitaki**
**Takahagi Ibaraki (JP)**
Inventor: **Akutsu, Yoji**
**1-5-3-403 Nishinarusawa**
**Hitachi Ibaraki (JP)**

(74) Representative: **Paget, Hugh Charles Edward et al,
MEWBURN ELLIS & CO. 2/3 Cursitor Street
London EC4A 1BQ (GB)**

Electron beam welding machine

This invention relates to an electron beam welding machine having a vacuum chamber in which in use a workpiece is located and an electron gun having beam adjusting means mounted on or adjacent the vacuum chamber.

In conventional electron beam welding machines, an electron gun comprising a cathode, grid, anode, and a beam adjusting means including a focusing coil and a deflecting coil is mounted on a welding chamber in which a workpiece is located. The electron beam generator is contained in a vacuum chamber and electron beams are directed towards the workpiece through an aperture in the wall of the welding chamber. Such a machine is disclosed, for example, in U.S. Patent No. 3,617,686.

In such machines, it is generally necessary to evacuate the welding chamber and the electron beam gun chamber by means of a vacuum pump and to maintain them at high vacuum of about $1.33 \times 10^{-2}$ Pa ($1 \times 10^{-4}$ Torr) and about $1.33 \times 10^{-3}$ Pa to $1.33.10^{-4}$ Pa ($1 \times 10^{-5}$ to $1 \times 10^{-6}$ Torr respectively. However, gases contained in the workpiece such as $H_2$ and $O_2$ and metal vapour from the workpiece itself are emitted from the surface of the workpiece during welding and lower the vacuum in both vacuum chambers. If a large number of molecules enter the electron beam gun chamber the insulation effect of the vacuum in the proximity of anode and cathode is reduced, so that microdischarge and flash-over discharge occur. Microdischarge results in the formation of blowholes at the weld zone, while flash-over discharge leads to the formation of recesses in the surface beads, blow-holes and sags. Furthermore, if flash-over discharge occurs an excess current relay operates to switch the apparatus off in order to protect it.

These discharge phenomena occur frequently when the thickness of the workpiece exceeds 100 mm because the number of free gas and metal vapour molecules formed during welding increases with increasing thickness of the workpiece. When a 100 mm thick killed steel is welded, for example, microdischarge occurs 1 to 5 times each 10 minutes and flash-over discharge about once in 20 minutes. The vacuum in this instance is $1.33 \times 10^{-1}$ Pa ($1 \times 10^{-3}$ Torr) near the aperture in the wall of the welding chamber, 1.33 Pa ($1 \times 10^{-2}$ Torr) near the workpiece and $1.33 \times 10^{-3}$ to $1.33 \times 10^{-4}$ Pa ($10^{-5}$ to $10^{-6}$ Torr) inside the electron beam gun chamber. Thus, the pressure ratio between the pressure in the region near the aperture in the welding chamber and that in the electron beam gun chamber may be as large as $10^2$—$10^3$ so that the gas and metal molecules are liable to be sucked into the electron beam gun chamber. As a result, molecules emitted from the surface of the workpiece can enter the electron beam gun chamber and instantaneously reduce the vacuum near the anode and cathode down to $1.33 \times 10^{-1}$ to $1.33 \times 10^{-2}$ Pa ($10^{-3}$—$10^{-4}$ Torr), thereby causing the discharge phenomena. Because of such discharge phenomena, it has been difficult to weld, cut or bore a workpiece of a thickness of 100 mm or more by means of electron beams using conventional machines.

There is also a prior art electron beam welding machine which has two beam adjusting means spaced from each other, and this is disclosed in GB Patent Specification No. 963,833. The two adjusting means, however, are fixed relatively so that the distance between them cannot be changed. Therefore workpieces of a thickness of 100 mm or more cannot be treated satisfactorily.

An object of the present invention is to provide an electron beam welding machine which can be used for welding, cutting or boring workpieces of various thickness, particularly thick workpieces, without causing discharge phenomena occuring during the process.

Molecules are emitted from the surface of a workpiece being welded with a given kinetic energy and can travel only a distance approximately equal to their free path. Thus if the workpiece is spaced from the electron beam gun by a distance greater than the mean free path of these molecules the number of molecules capable of reaching the electron beam gun will be greatly reduced so that the discharge phenomena can be checked. This is disclosed in copending EP—A—0017405 "Method of treating a workpiece with electron beams and apparatus therefor" filed on March 21, 1980 by the same applicant. When the workpiece is spaced from the electron beam gun by such a large distance, for example 1.3 m, it is necessary to provide a second beam adjusting means for preventing electron beams from scattering from the electron beam path but which is movable along the electron beam path so as to be able to focus the beam on the workpiece. The second beam adjusting means, though, must be aligned precisely with a line between the electron gun and the position of the workpiece to be treated.

The present invention thus provides a solution by providing second beam adjusting means so that divergence of the electron beam from its path, can be corrected accurately by accurate adjustment and alignment of the position of the second beam adjusting means.

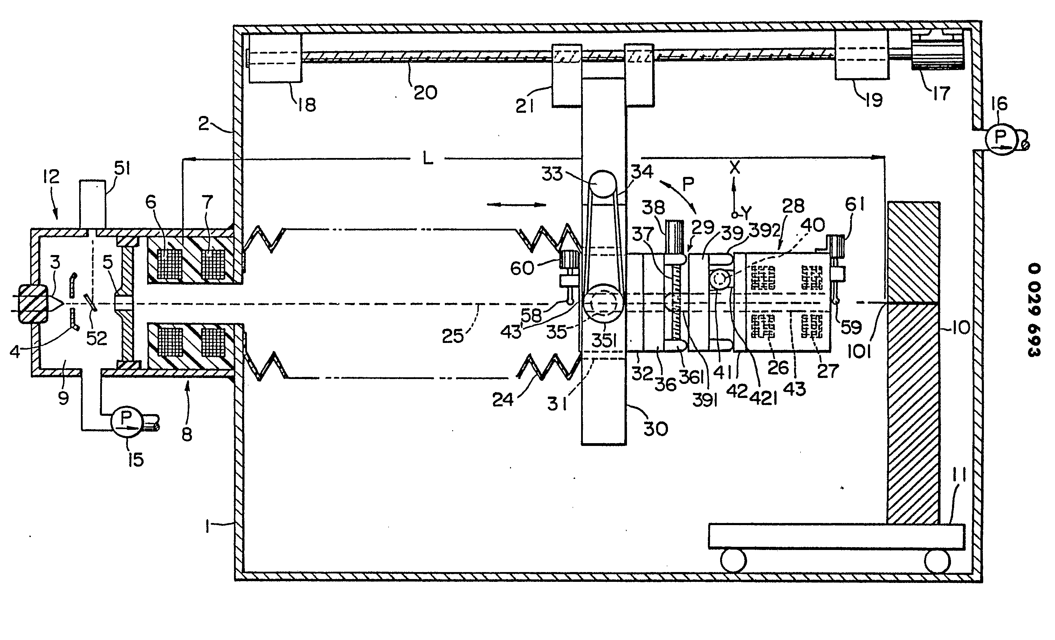

An embodiment of the present invention will now be described by way of example with reference to the accompanying drawing in which an electron beam welding machine embodying the present invention is shown in cross section.

An electron gun 12 is mounted in an air-tight manner on the wall 2 of a vacuum welding chamber 1 containing a workpiece 10 carried on a carriage 11. The electron gun 12 comprises a beam generator composed of a cathode 3, a grid 4, an anode 5, and a first beam adjusting means 8 comprising a focusing coil 6 and deflection coil 7. The electron beam generator of the electron gun 12 is contained in a vacuum chamber 9 of the electron gun and kept at a high vacuum, for example about $1.33 \times 10^{-3}$ Pa ($1 \times 10^{-5}$ Torr), by a vacuum pump 15.

The electron gun 12 emits an electron beam into the welding chamber 1 through an aperture in the wall 2, and the electron beam impinges on a target position 101 on the workpiece 10 to be welded. The welding chamber 1 is evacuated by a vacuum pump 16. On the electron beam path 25 between the first beam adjusting means 8 and the workpiece 10, a second beam adjusting means 28 is disposed so as to focus the by now diffused electron beam on the desired target spot 101 on the workpiece 10. The distance L between the first beam adjusting means 8 and the workpiece 10 is set to be greater than 1.3 m. The second beam adjusting means 28 comprises a focusing coil 26 to concentrate the electron beam 25 and a deflection coil 27, and is mounted on a position adjusting means 29 which is itself mounted on a positioning arm 20.

The positioning arm 20 comprises a rod rotatably supported by a pair of bearings 18,19 secured to the upper portion of the welding chamber 1. The arm 20 is fixed to a motor 17 at one end and is threaded over that part of its outer surface between the bearings 18 and 19. A pair of members 21 of a coupler 30 of the position adjusting means 29 are threadedly engaged with the threaded portion of the positioning arm 20. The position adjusting means 29 may thus be moved by rotation of the arm 20 by the motor 17 so that the second beam adjusting means 28 moves along the beam path 25. The coupler 30 is provided with a hole 31 into which a mounting base 32 is inserted. The sizes of the mounting base 32 and hole 31 are such that a certain amount of free play exists between them.

The mounting base 32 is provided with colinear lugs 35 extending perpendicularly to and on opposite sides of the beam path 25. The lugs 35 are inserted rotatably in a pair of holes in the side walls of the coupler hole 31. One of the lugs 35 is provided with a pulley 351, driven by a motor 33 through a belt 34 so that the second beam adjusting means 28 can be rotated about the lugs 35 as indicated by the arrow P to adjust the direction of the electron beam path 25.

The mounting base 32 is fitted with a seat 36 in which a threaded rod 37 driven by a motor 38 is rotatably mounted between projections 361. On the projections 361 of the seat 36, another seat 39 is mounted. The seat 39 has a boss 391 extending towards the seat 36. The boss 391 is provided with a threaded passage which is threadedly engaged with the threaded rod 37 such that the seat 39 may be displaced in either direction along the X-axis as indicated by the arrow X when the rod 37 is rotated by the motor 38. The seat 39 is also provided with projections 392 bearing a mount 42 on which is mounted the second beam adjusting means 28. The seat 39 is provided with a threaded rod 40 extending perpendicularly to the direction of the threaded rod 37, driven by a motor 41, and threadedly engaged with a boss 421 on the mount 42, so that, when the motor 41 rotates the threaded rod 40, the mount 42 is displaced in the direction of Y axis (perpendicular to the plane of the drawing).

The base 32, the seats 36,39 and mount 42 are each provided with a hole 43', 43 at their centres through which the electron beam 25 passes. The shafts of the threaded rods 37,40 are positioned so as not to block the beam path.

The beam path 25 between the wall 2 of the welding chamber 1 and the position adjusting means 29 is surrounded by a bellows or the like 24, which is mounted in an airtight manner on the wall 2 of the welding chamber 1 and the coupler 30.

With the above described electron beam welding machine, since the distance L between the first beam adjusting means 8 and the workpiece 10 can be set to be greater than 1.3 m by moving the carriage 11, gases emitted at the weld portion can be prevented from entering the electron gun 12, so that a sound weld is obtained. Furthermore, since the second beam adjusting means 28 can be displaced along the path of the electron beam 25 to any desired position by rotating the position setting arm 20, the electron beam can be focused accurately on the weld portion 101, thus producing sound, deeply penetrating welds.

The illustrated electron beam welding machine also has the following advantage. The second beam adjusting means 28 is mounted on the positioning arm 20 by the position adjusting means 29, which includes the rotary adjusting mechanism made up of the motor 33 and belt 34, and X-axis adjusting mechanism consisting of the motor 38 and threaded rod 37, and the Y-axis adjusting mechanism consisting of the motor 41 and threaded rod 40. Thus, if the position setting arm 20, the position adjusting means 29 or the second beam adjusting means 28 was not assembled in exactly the correct position, the center of the magnetic field of the second beam adjusting means 28 can still be aligned with the electron beam 25 by moving the adjusting means 28 in the directions of the X and Y axes or by rotating the second beam adjusting means about the lugs 35. Thus it is possible to perform electron beam welding under the best conditions by first setting the electron gun far enough away from the workpiece and then by accurately focusing the beam on the desired target point.

The electron gun 12 is also equipped with a laser oscillator 51 as a light source and with a mirror 52 for directing the laser beam from the laser oscillator 51 along a path which is coaxial with the electron beam path 25. The mirror 52 is mounted so as to be movable in the direction perpendicular to the beam path 25.

The second beam adjusting means 28 has two photodiodes 58, 59 one photodiode 58 being fitted on the coupler 30 and the other 59 being fitted to the side of the deflection coil 27 furthest from the mirror 52 (i.e. the right hand end in the drawing) and facing the workpiece 10. These photodiodes 58, 59 which function as detectors of the laser beam, are moved by the motors 60, 61 so that the photodiodes can be removably positioned on the central axis of the electron beam hole in the coupler 30 and on the central axis of the hole in the deflection coil 27.

To align the center of magnetic field of the second beam adjusting means 28 with the electron beam 25, the laser beam is aligned with the center of the magnetic field. The following process is carried out.

First, the photodiode 58 is driven by the motor 60 so as to coincide with the central axis of the electron beam hole of the coupler 30. The X- and Y-axis adjusting mechanisms are then operated to adjust the position of the second beam adjusting means 28 until the laser beam is detected by the photodiode 58. When this occurs the second beam adjusting means 28 is in the position in which the laser beam is aligned with the center of the entrance to electron beam passage 43.

Next, the photodiode 58 is returned to its original position by the motor 60, and the photodiode 59 is driven by the motor 61 to the central axis of the hole 43. The rotary adjusting mechanism 33, 35 is then operated so as to rotate the second beam adjusting means 28 until the photodiode 59 detects the laser beam. When this occurs the second beam adjusting means 28 is in the position in which the electron beam is aligned with the central axis of the hole 43 in the deflection coil 27. In this way, prior to welding, the center of the magnetic field of the second beam adjusting means is aligned accurately with the electron beam path.

Thus, it is possible to align the center of the magnetic field of the second beam adjusting means 28 with the electron beam 25. After carrying out the adjustment described above very little electron scattering occurs as the laser beam used to align the apparatus was emitted along a path coaxial with that of the electron beam path. Thus highly accurate adjustment is very easy and it is also possible to check that the device is correctly adjusted before welding is commenced.

Although motors, belts and threaded rods have been used as components of the adjusting mechanisms, other devices may of course be used. The laser oscillator may be replaced by other devices and the photodiodes may be replaced by other detecting devices such as phototransistors or silicon photocells.

With the illustrated electron beam welding device, very sound welds can be obtained in thicker workpieces.

**Claims**

1. An electron beam welding machine comprising:
a vacuum chamber (1) in which, in use, a workpiece (10) is located;
an electron gun (12) including a first beam adjusting means (8), said electron gun (12) being mounted on or adjacent said vacuum chamber (1); and
a second beam adjusting means (28) spaced from said first beam adjusting means (8) and adapted to adjust electron beams from said first beam adjusting means (8) so as to direct them to a desired position (101) on said workpiece (10); characterized in that:
said second beam adjusting means (28) is movable along the electron beam path (25); and
the machine is provided with a position adjusting means (29) for adjusting the position of said second beam adjusting means (28), said position adjusting means (29) including means (36,39) for moving said second beam adjusting means in a plane perpendicular to said electron beam path and means (33,34,35) for rotating said second beam adjusting means (31,32) about an axis which perpendicularly intersects the electron beam path (25).

2. A machine according to claim 1, wherein said means (42,39,36) for moving said second beam adjusting means in a plane perpendicular to the electron beam path comprises first (36,39) and second mechanisms (39,42) for moving said second beam adjusting means in a first direction perpendicular to the electron beam path in a second direction perpendicular to said first direction, respectively.

3. A machine according to claim 1 or claim 2 further comprising positioning means (20) for moving said second beam adjusting means (28) along said electron beam path (25) so that electron beams from said electron gun (12) are focused on the desired position (101) of the workpiece (10) the arrangement being such that the workpiece can be spaced from said electron gun by a distance (L) greater than the mean free path of any free molecules or atoms generated at the workpiece (10).

4. A machine according to any one of claims 1 to 3 further comprising means (51,58,59) for detecting, by use of a light beam, the alignment of the second beam adjusting means with respect to the electron beam axis.

5. A machine according to claim 4 wherein the alignment detecting means comprises a light source (51), reflective means (52) adapted to be disposed in said electron gun (12) to direct light from said source (51) along the electron beam path (25) towards the workpiece (10), and light detecting means (59) adapted to be mounted on said second beam adjusting means (28) between said second beam adjusting means (28) and said workpiece (10) so as to be coaxial with a passage (43) for the electron beam path through said second beam adjusting means (28).

6. A machine according to claim 5, further comprising light detecting means (58) adapted to be mounted on said position adjusting means (29) between said position adjusting means (29) and said electron gun (12) so as to be coaxial with a passage (43') for the electron beam through said position adjusting means (29).

7. A machine according to claim 5 or claim 6 wherein said light detecting means (58,59) are movable to positions in which they are not in the electron beam path (25).

8. A machine according to any one of claims 5 to 7 wherein said light source (51) is a laser oscillator.

**Patentansprüche**

1. Elektronenstrahl-Schweißmaschine, umfassend eine Vakuumkammer (1), in der im Betrieb ein Werkstück (10) angeordnet ist; eine Elektronenkanone (10) mit einer ersten Strahljustiereinrichtung (8), wobei die Elektronenkanone (12) an oder nahe der Vakuumkammer (1) montiert ist; und eine zweite Strahl-Justiereinrichtung (28), die in Abstand von der ersten Strahl-Justiereinrichtung (8) angeordnet und zur Justierung der Elektronenstrahlen von der ersten Strahl-Justiereinrichtung (8) derart ausgelegt ist, daß sie diese Strahlen auf eine gewünschte Stelle (101) auf dem Werkstück (10) richtet; dadurch gekennzeichnet, daß die zweite Strahl-Justiereinrichtung (28) längs der Elektronenstrahlbahn (25) bewegbar ist; und daß die Maschine mit einer Lage-Justiereinrichtung (29) zur Justierung der Lage der zweiten Strahl-Justiereinrichtung (28) versehen ist, wobei die Lage-Justiereinrichtung (29) eine Einrichtung (36, 39) zur Bewegung der zweiten Strahl-Justiereinrichtung in einer zu der Elektronenstrahlbahn senkrechten Ebene und eine Einrichtung (33, 34, 35) zum Drehen der zweiten Strahl-Justiereinrichtung (31, 32) um eine die Elektronenstrahlbahn (25) senkrecht schneidende Achse umfaßt.

2. Maschine nach Anspruch 1, wobei die Einrichtung (42, 39, 36) zum Bewegen der zweiten Strahl-Justiereinrichtung in einer zur Elektronenstrahlbahn senkrechten Ebene einen ersten (36, 39) und einen zweiten Mechanismus (39, 42) zum Bewegen der zweiten Strahl-Justiereinrichtung in einer zur Elektronenstrahlbahn senkrechten ersten Richtung bzw. in einer zu der ersten Richtung senkrechten zweiten Richtung umfaßt.

3. Maschine nach Anspruch 1 oder 2, weiterhin umfassend eine Postioniereinrichtung (20) zum Bewegen der zweiten Strahl-Justiereinrichtung (28) längs der Elektronenstrahlbahn (25), so daß Elektronenstrahlen aus der Elektronenkanone (12) auf die gewünschte Stelle (101) des Werkstücks (10) fokussiert werden, wobei die Anordnung so getroffen ist, daß das Werkstück von der Elektronenkanone um einen Abstand (L) entfernt sein kann, der größer ist als die mittlere freie Weglänge von an dem Werkstück (10) erzeugten freien Molekülen oder Atomen.

4. Maschine nach einem der Ansprüche 1 bis 3, ferner umfassend eine Einrichtung (51, 58, 59) zur Feststellung der Ausrichtung der zweiten Strahl-Justiereinrichtung bezüglich der Elektronenstrahlachse unter Verwendung eines Lichtstrahls.

5. Maschine nach Anspruch 4, wobei die Einrichtung zur Feststellung der Ausrichtung eine Lichtquelle (51), eine reflektierende Einrichtung (52), die zur Anordnung in der Elektronenkanone (12) derart ausgelegt ist, daß sie Licht von der Quelle (51) längs der Elektronenstrahlbahn (25) auf das Werkstück (10) richtet, sowie ein Lichtdetektoreinrichtung (59) umfaßt, die zu Anbringung an der zweiten Strahl-Justiereinrichtung (28) zwischen der zweiten Strahl-Justiereinrichtung (28) und dem Werkstück (10) derart ausgelegt ist, daß sie sich koaxial zu einer durch die zweite Strahl-Justiereinrichtung (28) verlaufende Durchführung (43) für die Elektronenstrahlbahn befindet.

6. Maschine nach Anspruch 5, ferner umfassend eine Lichtdetektoreinrichtung (58), die zur Anbringung an der Lage-Justiereinrichtung (29) zwischen der Lage-Justiereinrichtung (29) und der Elektronenkanone (12) derart ausgelegt ist, daß sie sich koaxial zu einer durch die Lage-Justiereinrichtung (29) verlaufenden Durchführung (43') für den Elektronenstrahl befindet.

7. Maschine nach Anspruch 5 oder 6, wobei die Lichtdetektoreinrichtungen (58, 59) in Stellungen bewegbar sind, in denen sie sich nicht in der Elektronenstrahlbahn (25) befinden.

8. Maschine nach einem der Ansprüche 5 bis 7, wobei die Lichtquelle (51) ein Laser-Oszillator ist.

**Revendications**

1. Appareil de soudage à faisceau électronique portant une chambre à vide (1) dans laquelle, en cours d'utilisation, une pièce à traiter (17) est située, un canon à électrons (12) comprenant des premiers moyens (8) de réglage du faisceau et qui est monté sur ou au voisinage de ladite chambre à vide (1), et des seconds moyens (28) de réglage du faisceau distants desdits premiers moyens (8) de réglage du faisceau et aptes à régler des faisceaux électroniques provenant desdits moyens (8) de réglage du faisceau de manière à les diriger sur une position désirée (101) sur ladite pièce à traiter (10), caractérisé en ce que lesdits seconds moyens (28) de réglage du faisceau sont déplaçables le long du trajet (25) du faisceau électronique, et que l'appareil est équipé de moyens (29) de réglage en position, servant à régler la position desdits seconds moyens (28) de réglage du faisceau, lesdits moyens (29) de réglage en position comprenant des moyens (36, 39) pour déplacer les seconds moyens de réglage du faisceau dans un plan perpendiculaire audit trajet du faisceau électronique, et des moyens (33,34,35) pour faire tourner lesdits seconds moyens (31,32) de réglage du faisceau autour d'un axe qui recoupe à angle droit le trajet (25) du faisceau électronique.

2. Appareil selon la revendication 1, caractérisé en ce que lesdits moyens (42, 39, 36) servant à déplacer les seconds moyens de réglage du faisceau dans un plan perpendiculaire au trajet du faisceau électronique comprennent des premiers mécanismes (36, 37) et des seconds mécanismes (39, 42) servant à déplacer respectivement les seconds moyens de réglage de faisceau dans une première direction perpendiculaire au trajet du faisceau électronique et dans une seconde direction perpendiculaire à ladite première direction.

3. Appareil selon l'une quelconque des revendications 1 et 2, caractérisé en ce qu'il comporte en outre des moyens de positionnement (20) servant à déplacer lesdits seconds moyens (28) réglage du faisceau le long dudit trajet (25) du faisceau électronique de sorte que les faisceau électroniques provenant dudit canon à électrons sont focalisés sur la position désirée (101) de la pièce à traiter (10), l'agencement étant tel que la pièce à traiter peut être écartée dudit canon à électrons d'une distance (L) supérieur au libre parcours moyen de molécules ou d'atomes libres produits au niveau de la pièce à traiter (10).

4. Appareil selon l'une quelconque des revendications 1 à 3, caractérisé en ce qu'il comporte en outre des moyens (51, 58, 59) servant à détecter, grâce à l'utilisation d'un faisceau de lumière, l'alignement des seconds moyens de réglage du faisceau par rapport à l'axe du faisceau électronique.

5. Appareil selon la revendication 4, caractérisé en ce que les dispositifs de détection d'alignement comprennent une source de lumière (51), des moyens réfléchissants (52) aptes à êtres disposés dans ledit canon à électrons (12) de manière à diriger la lumière depuis ladite source (51) le long du trajet (25) du faisceau électronique, en direction de la pièce à traiter (10), et des moyens de détection de lumière (59) aptes à être montés sur les seconds moyens (28) de réglage du faisceau entre ces moyens (28) et ladite pièce à traiter (10) de manière à être coaxiaux avec un passage (43) pour le trajet du faisceau électronique à travers les seconds moyens (28) de réglage du faisceau.

6. Appareil selon la revendication 5, caractérisé en ce qu'il comporte en outre des moyens de détection de lumière (58) apte à être montés sur lesdits moyens de réglage en position (29) entre ces moyens (29) et ledit canon à électrons (12) de manière à être coaxiaux à un passage (43') pour le faisceau électronique à travers lesdits moyens de réglage en position (29).

7. Appareil selon l'une quelconque des revendications 5 et 6, caractérisé en ce que lesdits moyens de détection de lumière (58, 59) sont déplaçables dans des positions dans lesquels ils ne sont pas sur le trajet (25) du faisceau électronique.

8. Appareil selon l'une quelconque des revendications 5 à 7, caractérisé en ce que ladite source de lumière (51) est un oscillateur laser.